# EUROPEAN PATENT APPLICATION

(11) **EP 4 625 757 A1**
(43) Date of publication of application: **01.10.2025**
(21) Application number: 25161259.4
(22) Date of filing: 03.03.2025
(51) Int. Cl.: H02J 7/00, G01R 31/392, H01M 10/48

(54) **PERFORMANCE ANALYSIS METHOD OF ENERGY STORAGE SYSTEM AND RELATED DEVICE**

(30) Priority: 30.03.2024 CN 202410381779; 22.05.2024 WO PCT/CN2024/094719
(71) Applicant: Eve Energy Storage Co., Ltd, Wuhan, Hubei 430074 (CN)
(72) Inventor: SHE, Shi, Wuhan, Hubei, 430074 (CN); LEI, Yan, Wuhan, Hubei, 430074 (CN)
(74) Representative: Berggren Oy

(57) **Abstract**

A performance analysis method of an energy storage system and a related device are disclosed in the present application, the method includes: processing at least one data file of charging and discharging of the energy storage system to obtain target charging and discharging data; and determining a start node and an end node in a charging and discharging cycle of the energy storage system according to the charging and discharging cycle data of the energy storage object(s) in the target charging and discharging data, thereby accurately analyzing the performance of the energy storage system to avoid misreading or omission and increase the efficiency of processing the charging and discharging data.

## Description

### TECHNICAL FIELD

The present application relates to the field of battery technologies, and in particular to a performance analysis method of an energy storage system and a related device.

### BACKGROUND

The operation and maintenance of the energy storage systems require battery management systems (BMS) for execution. The battery management systems combine the electronic technologies and software and act as the brains of the energy storage systems, ensuring that the batteries maintain balance and safety and conveying important information (e.g., available capacity) to the users or the connected energy storage systems. In related art, the charging and discharging data of the energy storage system is usually exported from a BMS in the form of files, and thus the performance of the energy storage system may be determined by analyzing the data in the files.

However, the files exported from the BMS typically contain tens of thousands of lines of data. If processed manually, not only is the process time-consuming, laborious and inefficient, but the process also has a high risk of misreading or omission, resulting in poor accuracy in the performance analysis of the energy storage system.

### SUMMARY

In a first aspect, the present application provide a performance analysis method of an energy storage system, which includes:
process at least one data file of charging and discharging of the energy storage system to obtain target charging and discharging data, the target charging and discharging data including charging and discharging cycle data after at least one charging and discharging cycle of the energy storage system, the charging and discharging cycle data including charging and discharging cycle data of at least one energy storage object, and the at least one energy storage object including any one of a battery cluster, a battery pack, a battery module and a battery cell in the energy storage system;
determine a start node and an end node in the charging and discharging cycle of the energy storage system according to the charging and discharging cycle data of the at least one energy storage object; and
determine the discharging start node according to the intermediate data.

In a second aspect, the present application provides a performance analysis device for an energy storage system, which includes:
a first processing unit used to process at least one data file of charging and discharging of the energy storage system to obtain target charging and discharging data, the target charging and discharging data including charging and discharging cycle data after at least one charging and discharging cycle of the energy storage system, the charging and discharging cycle data including charging and discharging cycle data of at least one energy storage object, and the at least one energy storage object including any one of a battery cluster, a battery pack, a battery module and a battery cell in the energy storage system;
a determination unit used to determine a start node and an end node in the charging and discharging cycle of the energy storage system according to the charging and discharging cycle data of the at least one energy storage object; and
a second processing unit used to process the target charging and discharging data according to the start node and the end node to obtain a performance analysis result of the energy storage system.

In a third aspect, the present application provides an electronic device, the electronic device includes a memory and a processor, the memory has stores a plurality of instructions; the processor loads the instructions from the memory to perform following steps: processing at least one data file of charging and discharging of the energy storage system to obtain target charging and discharging data, the target charging and discharging data including charging and discharging cycle data after at least one charging and discharging cycle of the energy storage system, the charging and discharging cycle data including charging and discharging cycle data of at least one energy storage object, and the at least one energy storage object including any one of a battery cluster, a battery pack, a battery module and a battery cell in the energy storage system; determining a start node and an end node in the charging and discharging cycle of the energy storage system according to the charging and discharging cycle data of the at least one energy storage object; and determining the discharging start node according to the intermediate data.

In a fourth aspect, the present application provides a computer-readable storage medium, which stores a plurality of instructions suitable for a processor to load and perform following steps: processing at least one data file of charging and discharging of the energy storage system to obtain target charging and discharging data, the target charging and discharging data including charging and discharging cycle data after at least one charging and discharging cycle of the energy storage system, the charging and discharging cycle data including charging and discharging cycle data of at least one energy storage object, and the at least one energy storage object including any one of a battery cluster, a battery pack, a battery module and a battery cell in the energy storage system; determining a start node and an end node in the charging and discharging cycle of the energy storage system according to the charging and discharging cycle data of the at least one energy storage object; and determining the discharging start node according to the intermediate data.

In a fifth aspect, the present application provides a computer program product, including a computer program or instructions that are executed by a processor to perform following steps: processing at least one data file of charging and discharging of the energy storage system to obtain target charging and discharging data, the target charging and discharging data including charging and discharging cycle data after at least one charging and discharging cycle of the energy storage system, the charging and discharging cycle data including charging and discharging cycle data of at least one energy storage object, and the at least one energy storage object including any one of a battery cluster, a battery pack, a battery module and a battery cell in the energy storage system; determining a start node and an end node in the charging and discharging cycle of the energy storage system according to the charging and discharging cycle data of the at least one energy storage object; and determining the discharging start node according to the intermediate data.

In the performance analysis method of the energy storage system provided in the present application, the at least one data file of charging and discharging of the energy storage system is processed to obtain the target charging and discharging data; a start node and an end node in the charging and discharging cycle of the energy storage system are determined according to charging and discharging cycle data of at least one energy storage object, and thus the start node and the end node may be used for location, and the target charging and discharging data is processed to obtain the performance analysis result of the energy storage system. Therefore, the process of charging and discharging data is achieved without the need for manual methods, which may not only avoid the situation of misreading and omission, but also improve the processing efficiency of the charging and discharging data of the energy storage system. In addition, the charging and discharging cycle data of the energy storage object(s) is directly used to locate the start node and the end node in the charging and discharging cycle of the energy storage system, which has a relatively high accuracy, thereby accurately analyzing the performance of the energy storage system.

### BRIEF DESCRIPTION OF THE DRAWINGS

FIG. 1 is a flowchart of a performance analysis method of an energy storage system provided in embodiments of the present application;
FIG. 2 is a visual operation interface of a performance analysis method of an energy storage system provided in embodiments of the present application;
FIG. 3 is a flowchart of a first sub-process of a performance analysis method of an energy storage system provided in embodiments of the present application;
FIG. 4 is a flowchart of a second sub-process of a performance analysis method of an energy storage system provided in embodiments of the present application;
FIG. 5 is a flowchart of a third sub-process of a performance analysis method of an energy storage system provided in embodiments of the present application;
FIG. 6 is a flowchart of a fourth sub-process of a performance analysis method of an energy storage system provided in embodiments of the present application;
FIG. 7 is a flowchart of a fifth sub-process of a performance analysis method of an energy storage system provided in embodiments of the present application;
FIG. 8 is a flowchart of a sixth sub-process of a performance analysis method of an energy storage system provided in embodiments of the present application;
FIG. 9 is a flowchart of a seventh sub-process of a performance analysis method of an energy storage system provided in embodiments of the present application;
FIG. 10 is a flowchart of an eighth sub-process of a performance analysis method of an energy storage system provided in embodiments of the present application;
FIG. 11 is a schematic block diagram of a performance analysis device of an energy storage system provided in embodiments of the present application; and
FIG. 12 is a schematic block diagram of an electronic device provided in embodiments of the present application.

### DETAILED DESCRIPTION

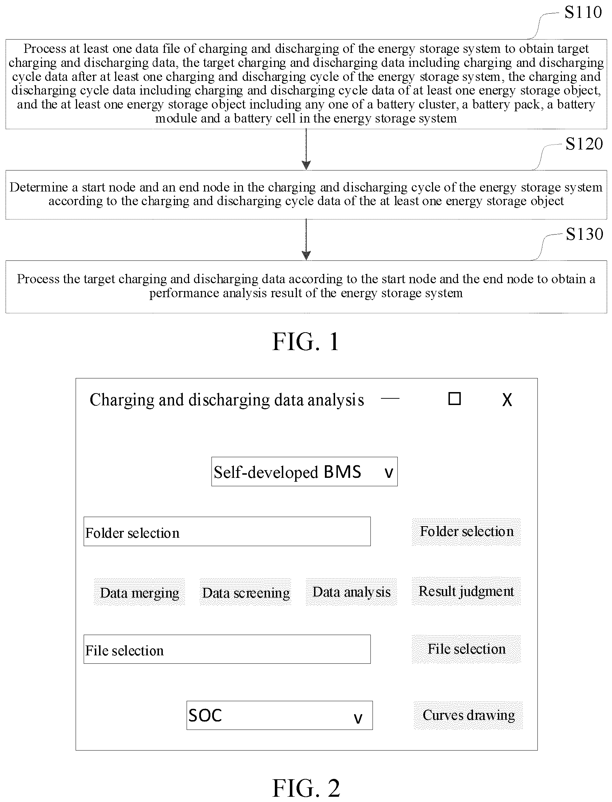

Referring to FIG. 1, FIG. 1 is a flowchart of a performance analysis method of an energy storage system provided in embodiments of the present application. The performance analysis method of the energy storage system provided in the present application is applied in the terminal device, and the method is executed through the application software installed in the terminal device. The terminal device may be a desktop computer, a laptop computer, a tablet computer, a mobile phone, an electric vehicle terminal, or the like.

The performance analysis method of the energy storage system provided in the present application is mainly used for the performance analysis of the energy storage system before the energy storage system leaves the factory, which may improve the quality of the energy storage system after the energy storage system leaves the factory. The performance analysis method of the energy storage system provided in the present application is mainly aimed at the performance analysis of the energy storage system before the energy storage system leaves the factory, and may also be applied to other application scenarios such as the performance analysis of the energy storage system after the energy storage system leaves the factory.

The performance analysis method of the energy storage system is described in detail below.

As shown in FIG. 1, the method includes steps S110 to S130.

In S110, at least one data file of charging and discharging of the energy storage system is processed to obtain target charging and discharging data. The target charging and discharging data includes charging and discharging cycle data after at least one charging and discharging cycle of the energy storage system, the charging and discharging cycle data includes charging and discharging cycle data of at least one energy storage object, and the energy storage object includes any one of a battery cluster, a battery pack, a battery module and a battery cell in the energy storage system.

In the embodiments, the data file(s) record the charging and discharging data during the charging and discharging process of the energy storage system. The data file(s) may be collected by the battery management system that matches the energy storage system and exported. The target charging and discharging data is obtained after processing the at least one data file. The target charging and discharging data includes the charging and discharging cycle data generated after the energy storage system has performed at least one complete charging and discharging cycle. The charging and discharging cycle of the energy storage system means that the energy storage system performs a complete charging process and a complete discharging process. That is, energy storage system performs one charging and discharging cycle.

Since the energy storage system may span multiple natural days during one charging and discharging cycle, a plurality of data files may be exported from the battery management system after one charging and discharging cycle is finished. In order to ensure that the target charging and discharging data contains the charging and discharging cycle data after the at least one charging and discharging cycle of the energy storage system, the plurality of data files after charging and discharging of the energy storage system may need to be processed to obtain the target charging and discharging data.

In addition, the energy storage object mentioned in the present application refers to the energy storage unit that constitutes the energy storage system, and the energy storage unit may be either the battery cluster, the battery pack, the battery module, or the battery cell in the energy storage system. That is, when the charging and discharging cycle data of the energy storage object(s) is used to determine a start node and an end node in the charging and discharging cycle of the energy storage system in the present application, the charging and discharging cycle data may be from any one of the battery cluster, the battery pack, the battery module and the battery cell, but the accuracy will differ. Therefore, in order to determine the start node and the end node in the charging and discharging cycle of the energy storage system more accurately, the charging and discharging cycle data of the battery cell(s) is preferred to determine the start node and the end node in the charging and discharging cycle of the energy storage system in the present application.

The data file(s) may be either data file(s) after charging and discharging of the energy storage object(s) in the energy storage system, or data file(s) after charging and discharging of the energy storage system. That is, the number and type of data files may be determined according to the practical application, and will not be specifically limited in the present application.

In other embodiments, before the step S110, the performance analysis method further includes a step in which a file folder containing one or more data files of charging and discharging of the energy storage system is determined to obtain the at least one data file.

The data file(s) collected by the battery management system for charging and discharging of the energy storage system are usually placed in a corresponding file folder. Therefore, in the present application, the file folder containing one or more data files of charging and discharging of the energy storage system needs to be determined before the at least one data file after charging and discharging of the energy storage system is processed, and then the data file(s) are obtained from the determined corresponding file folder. Thus, the at least one data file after charging and discharging of the energy storage system may be processed to obtain the target charging and discharging data.

In the embodiments, during the performance analysis process of the energy storage system, a visual form as shown in FIG. 2 may be adopted for human-computer interaction. In the visual operation interface shown in FIG. 2, when a performance analysis needs to be performed on a certain energy storage system, a battery management system corresponding to the energy storage system (e.g., a self-developed battery management system) needs to be determined in advance; and then, a data import module may be provided for folder addressing to locate the folder address where the data file(s) of charging and discharging of the energy storage system are located, and thus the corresponding data file(s) may be obtained and processed after the file folder containing one or more data files of charging and discharging of the energy storage system is determined. As a result, the target charging and discharging data for analyzing the performance of the energy storage system is obtained. The self-developed battery management system may be a battery management system independently developed by EVE Energy Co., Ltd.

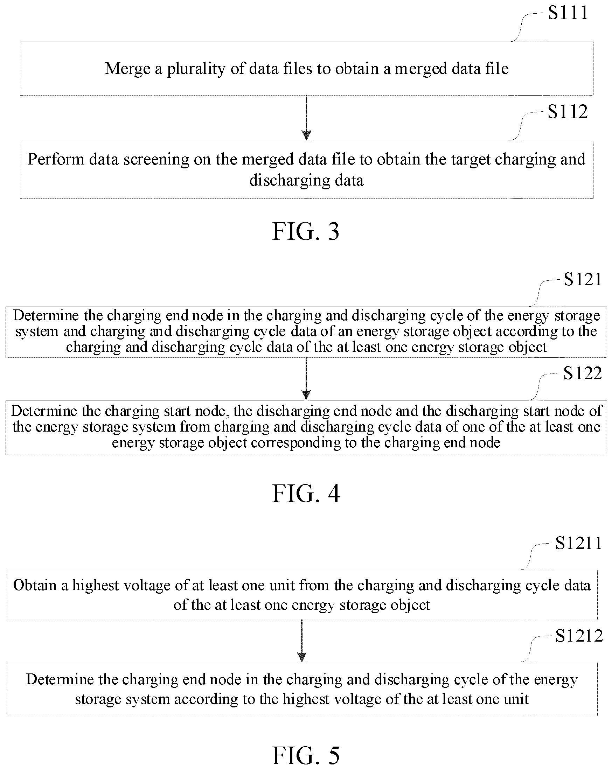

In other embodiments, as shown in FIG. 3, the step S110 includes steps S111 and S112.

In S111, a plurality of data files are merged to obtain a merged data file;

In S112, data screening is performed on the merged data file to obtain the target charging and discharging data.

In the embodiments, since the energy storage system spans multiple natural days when completing one charging and discharging cycle, the battery management system generates the plurality of data files at different dates, and thus the file merging processing is required to facilitate obtaining a data file that contains a complete charging and discharging cycle of the energy storage system (i.e., the merged data file). However, the merged data file may contain data from which the energy storage system did not complete a charging and discharging cycle, and thus the data screening process is required on the merged data file to obtain the target charging and discharging data.

For example, as shown in FIG. 2, when the visual operation is performed, a data merging module and a data screening module may be provided in the present application. The data merging module may merge data files having the same attributes, so that the merged data file contains charging and discharging cycle data of all energy storage objects in the energy storage system; the data screening module may read the data in the merged data file and screen out valuable data columns (i.e., the target charging and discharging data). The target charging and discharging data may be stored in a file with a specific format, such as an Excel file.

The target charging and discharging data may be stored in multiple files or a single file. When the target charging and discharging data stored in multiple files, each file may be used to store charging and discharging cycle data of one energy storage object. That is, the storing manner and the storage type of the target charging and discharging data may be determined according to the practical application, and will not be specifically limited in the present application.

During the data screening process on the merged data file, the fluctuation data generated during the charging and discharging process of the energy storage system is required to be deleted. The fluctuation data may be data with sudden large fluctuations in a short period of time, data with a value of 0, data with a negative value, or the like.

In other embodiments, after the data screening process on the merged data file, the performance analysis method further includes a step in which the screened data is classified and saved into at least one file of target charging and discharging cycle data.

In the embodiments, the target charging and discharging data is saved in the at least one file of the target charging and discharging cycle data, and each file of the target charging and discharging cycle data may store charging and discharging data, having the same attribute, of the energy storage object(s), where the attribute may refer to a temperature, a voltage, a capacity, a state of charge, a current, a service live of the energy storage object(s), etc. That is, one file of the target charging and discharging cycle data includes any one of the voltage data, temperature data, capacity data, state data of charge, current data, service life data of the energy storage object(s), etc., of the at least one energy storage object in the energy storage system.

The naming and format of the target charging and discharging cycle data file may be preset before the generation of the charging and discharging data of the energy storage system, or may be set after the classifying process of the screened data, which may be selected according to the practical application and will not be specifically limited in the present application.

In S 120, the start node and the end node in the charging and discharging cycle of the energy storage system are determined according to the charging and discharging cycle data of at least one energy storage object.

In the process of determining the start node and the end node in the charging and discharging cycle of the energy storage system using the charging and discharging cycle data of the energy storage object(s), the start node and the end node may be determined through the voltage, current, electric capacity, state of charge (SOC), etc., in the charging and discharging cycle data of the energy storage object(s). The specific determination manner may be based on the charging and discharging strategy of the energy storage system, which will not be specifically limited in the present application.

In addition, the start node and the end node in the charging and discharging cycle of the energy storage system may be determined by using charging and discharging cycle data of one energy storage object, or charging and discharging cycle data of multiple energy storage objects in the present application. For example, when the voltage in the charging and discharging cycle data of one energy storage object is used to determine the start node and the end node, the highest voltage of a unit in the charging and discharging cycle data of the energy storage object may be used to determine the start node and the end node. When the charging and discharging cycle data of multiple energy storage objects is used to determine the start node and the end node, the highest voltage of a unit in the charging and discharging cycle data of each energy storage object may be obtained, and then the highest voltage of each unit may be processed to obtain the highest voltage of a target unit, and finally the start node and the end node may be determined through the highest voltage of the target unit. The highest voltage of the target unit may be the average of the highest voltages of multiple units.

In other embodiments, as shown in FIG. 4, the step S120 includes steps S121 and S122.

In S121, a charging end node in the charging and discharging cycle of the energy storage system and charging and discharging cycle data of an energy storage object corresponding to the charging end node are determined according to the charging and discharging cycle data of at least one energy storage object.

In S122, a charging start node, a discharging end node and a discharging start node in the charging and discharging cycle of the energy storage system are determined from charging and discharging cycle data of an energy storage object corresponding to the charging end node.

In the embodiments, the start node includes the charging start node and the discharging start node, and the end node includes the charging end node and the discharging end node. In addition, the charging strategy of the energy storage system provided in the present application is that charging is stopped after the voltage(s) of the energy storage object(s) in the energy storage system reach respective maximum value(s). In the present application, in order to obtain the charging start node, the discharging start node, the charging end node and the discharging end node in the charging and discharging cycle of the energy storage system more accurately, the charging end node of the energy storage system may be firstly determined from the highest voltage(s) of unit(s) in the charging and discharging cycle data of the at least one energy storage object in the target charging and discharging data, and on this basis, the charging start node, the discharging end node and the discharging start node in the charging and discharging cycle of the energy storage system are determined from the corresponding charging and discharging cycle data of the energy storage object.

In some possible implementations, any one of the charging start node, the discharging end node and the discharging start node may also be firstly determined, and then the other nodes (including the charging end node) are determined. The manner in which one of the nodes is firstly determined may be chosen according to the charging and discharging cycle strategy of the energy storage system. Therefore, the order of determining the charging end node, the charging start node, the discharging end node and the discharging start node in the charging and discharging cycle of the energy storage system may be determined according to the practical application, and will not be specifically limited in the present application

In other embodiments, as shown in FIG. 5, the step S121 includes steps S1211 and S1212.

S1211, a highest voltage of at least one unit is obtained from the charging and discharging cycle data of at least one energy storage object.

S1212, the charging end node in the charging and discharging cycle of the energy storage system is determined according to the highest voltage of the at least one unit.

The highest voltage of the energy storage object is the highest voltage during one charging and discharging cycle of the energy storage system. When the highest voltage of the at least one unit is obtained from the charging and discharging cycle data of the at least one energy storage object, the energy storage system may be determined to have completed charging at this time, and this node may serve as the charging end node of the energy storage system. The highest voltage of the unit may be not less than 3.65 V. It will be noted that the "unit" mentioned in the present application refers to a battery cell. That is, 3.65 V may be the highest voltage of the cell.

In the present application, the highest voltage of one unit may be obtained from the charging and discharging cycle data of one energy storage object, and then the node corresponding to the highest voltage of the unit directly serves as the charging end node in the charging and discharging cycle of the energy storage system. In addition, the highest voltages of multiple units may also be obtained from the charging and discharging cycle data of the energy storage object. In this case, the multiple units need to go through at least one charging and discharging cycle, and then the node corresponding to the highest voltage of one of the multiple units may serve as the charging end node. It will be noted that, when the node corresponding to the highest voltage of the one unit serves as the charging end node, the highest voltage of the one unit must be ensured to exist in the data where a complete charging and discharging cycle is completed.

In addition, the highest voltage of an energy storage object may be obtained from the charging and discharging cycle data of multiple energy storage objects, and then the node corresponding to the highest voltage of one of the energy storage objects with the highest voltage value directly serves as the charging end node in the charging and discharging cycle of the energy storage system. The node corresponding to the highest voltage of one of the energy storage objects with the lowest voltage value may also serve as the charging end node in the charging and discharging cycle of the energy storage system, or the average voltage of the highest voltages of the multiple energy storage objects may also be used to determine the charging end node in the charging and discharging cycle of the energy storage system. The specific determination manner may be chosen according to the practical application, and will not be specifically limited in the present application.

In the present application, when the charging end node in the charging and discharging cycle of the energy storage system is determined according to the highest voltage of the unit, the highest voltage of a unit in each energy storage object may also be obtained from the charging and discharging cycle data of multiple energy storage objects; and then a target highest voltage is generated according to the multiple highest voltages, the target highest voltage may be the average of the multiple highest voltages; and next the charging end node in the charging and discharging cycle of the energy storage system may be determined according to the node corresponding to the target highest voltage.

Furthermore, the charging end node in the charging and discharging cycle of the energy storage system may be determined by using the highest voltage of the at least one unit or the highest voltage of the at least one energy storage system, which may be chosen according to the practical application, and will not be specifically limited in the present application.

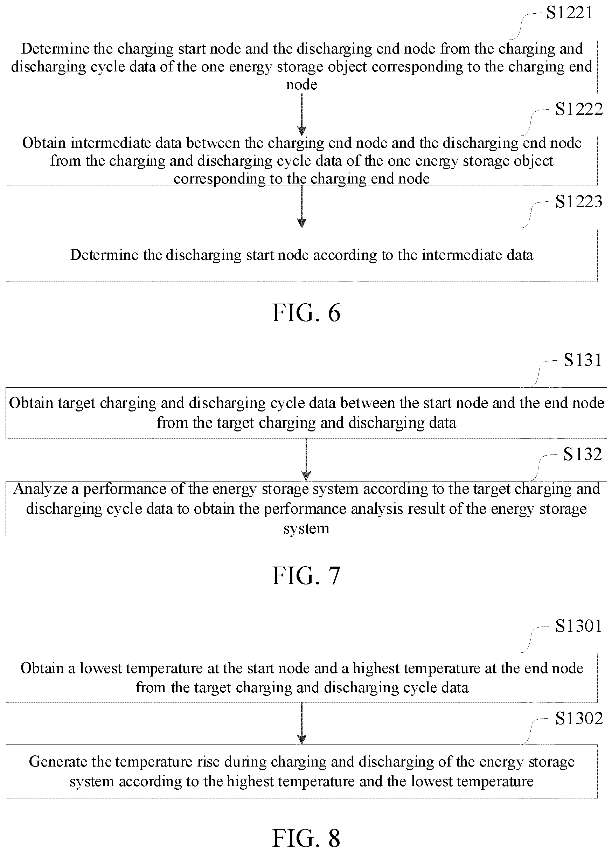

In other embodiments, as shown in FIG. 6, the step S122 includes steps S1221, S 1222 and S1223.

In S1221, the charging start node and discharging end node are determined from the charging and discharging cycle data of the energy storage object corresponding to the charging end node.

In S1222, intermediate data between the charging end node and the discharging end node is obtained from the charging and discharging cycle data of the energy storage object corresponding to the charging end node.

In S 1223, the discharging start node is determined according to the intermediate data.

In the embodiments, after the charging end node of the energy storage system is determined, the charging end node may serve as an end node, and the data tail line where the "stack minimum discharge capacity" is at its minimum in the charging and discharging data of the corresponding energy storage object may be captured before the end node. The node at this time may represent that the energy storage system is about to start the charging process, thus the charging start node of the energy storage system may be determined.

In addition, the charging end node may serve as the end node, and a node at which the "minimum voltage of the unit" is at its minimum in the charging and discharging data after the end node is captured in the charging and discharging cycle data of the corresponding energy storage object. If the battery management system determines that the minimum voltage of the unit is not greater than a preset voltage, such as 2.8V, the battery management system issues a discharge stop command simultaneously, and the node at which the battery management system issues the discharge stop command may serve as the discharging end node of the energy storage system. 2.8V refers to the minimum voltage of the battery cell, and the minimum voltage of the battery cell may also be greater than 2.8V. The specific arrangement may be chosen according to the practical application, and will not be specifically limited in the present application.

After the discharging end node of the energy storage system is determined, the charging end node and the discharging end node of the energy storage system may serve as datum marks, and data at a position between the two nodes (i.e., the intermediate data) may be captured from the charging and discharging cycle data of the corresponding energy storage object. Then, the data where the "stack minimum charge capacity" is at its minimum may be captured from the intermediate data. The node at this time may mean that the energy storage system is about to start the discharging process, and the node corresponding to the data is the discharging start node of the energy storage system.

The terms such as the highest voltage of the unit, the lowest voltage of the unit, the stack minimum discharge capacity, and the stack minimum charge capacity mentioned in the present application may refer to naming manners of the charging and discharging cycle data of the unit in the data file. That is, the naming manner of the voltage, the current, the electric capacity, etc., mentioned in the present application in the data file may be determined according to the practical application, and will not be specifically limited in the present application.

In S130, the target charging and discharging data is processed according to the start node and the end node to obtain a performance analysis result of the energy storage system.

After the start node and the end node in the charging and discharging cycle of the energy storage system is determined, the data between the nodes in the target charging and discharging data may be completely extracted and analyzed, thereby accurately analyzing the performance of the energy storage system.

The data between the start node and the end node in the target charging and discharging data may be the data after the charging and discharging cycle of one energy storage object in the energy storage system, the data after charging and discharging cycles of multiple of all energy storage objects, or the data after charging and discharging cycles of all the energy storage objects in the energy storage system, which may be chosen according to the practical application, and will not be specifically limited in the present application.

For example, as shown in FIG. 2, during the visual operation in the present application, a button of data analysis may be provided on the interface. The button may correspond to a data analysis module, which analyzes the screened data files to obtain the cycle nodes of the complete charging and discharging cycle, the charging start node, the charging end node, the discharging start node and the discharging end node, calculates the temperature rise and energy efficiency of the system during charging and discharging, and finally outputs an analysis result file. The analysis result file may be chosen by the file selection on the interface.

In other embodiments, as shown in FIG. 7, the step S130 includes steps S131 and S132.

In S131, target charging and discharging cycle data is obtained between the start node and the end node from the target charging and discharging data.

In S132, a performance of the energy storage system is analyzed according to the target charging and discharging cycle data to obtain the performance analysis result of the energy storage system.

In the embodiments, the start node includes the charging start node and the discharging start node, and the end node includes the charging end node and the discharging end node. After the charging start node, the discharging start node, the charging end node and the discharging end node are determined, the data between the charging start node and the charging end node and the data between the discharging start node and the discharging end node may be extracted from the target charging and discharging data to serve as the target charging and discharging cycle data, thereby accurately analyzing the performance of the energy storage system. The performance analysis result of the energy storage system may include at least one of a temperature rise during charging and discharging, an energy efficiency during charging and discharging and a charging and discharging capacity, where the temperature rise during charging and discharging may include a temperature rise during charging and a temperature rise during discharging.

The target charging and discharging cycle data may be the data after one energy storage object in the energy storage system has completed the charging and discharging cycle, the data after multiple of all energy storage objects in the energy storage system have completed the charging and discharging cycle, or the data after all the energy storage objects in the energy storage system have completed the charging and discharging cycle, which may be chosen according to the practical application, and will not be specifically limited in the present application.

In other embodiments, as shown in FIG. 8, the step S132 includes steps S1301 and S1302.

In S1301, a lowest temperature at the start node and a highest temperature at the end node are obtained from the target charging and discharging cycle data.

In S1302, the temperature rise during charging and discharging of the energy storage system is generated according to the highest temperature and the lowest temperature.

In the embodiments, the lowest temperature at the start node refers to the temperature of a unit with the lowest temperature among all units at the start node, and the highest temperature at the end node refers to the temperature of a unit with the highest temperature among all the units at the end node. In the present application, the temperature value of a unit with the lowest temperature at the charging start node, the temperature value of a unit with the highest temperature at the charging end node, the temperature value of a unit with the lowest temperature at the discharging start node, and the temperature value of a unit with the highest temperature at the discharging end node may be obtained from the target charging and discharging cycle data, and the four temperature values may be referred to as a first unit temperature, a second unit temperature, a third unit temperature and a fourth unit temperature, respectively. Then, the temperature rise during charging of the energy storage system may be generated according to the first unit temperature and the second unit temperature, and the temperature rise during discharging may be generated according to the third unit temperature and the fourth unit temperature. The temperature rise refers to the temperature increase of the energy storage system during the charging process or the discharging process.

The lowest temperature at the start node may also be represented by the average temperature of some of or all the units at the start node, and the highest temperature at the end node may also be represented by the average temperature of some of or all the units at the end node. That is, the lowest temperature at the start node and the highest temperature at the end node may be chosen according to the practical application, and will not be specifically limited in the present application.

In addition, after the temperature rise during charging and the temperature rise during discharging of the energy storage system are obtained, the performance of the energy storage system may be judged against a preset temperature rise threshold. A judgment module may be used to judge whether the performance of the energy storage system meets the standard, and the judgment module corresponds to the button of result judgment shown in FIG. 2.

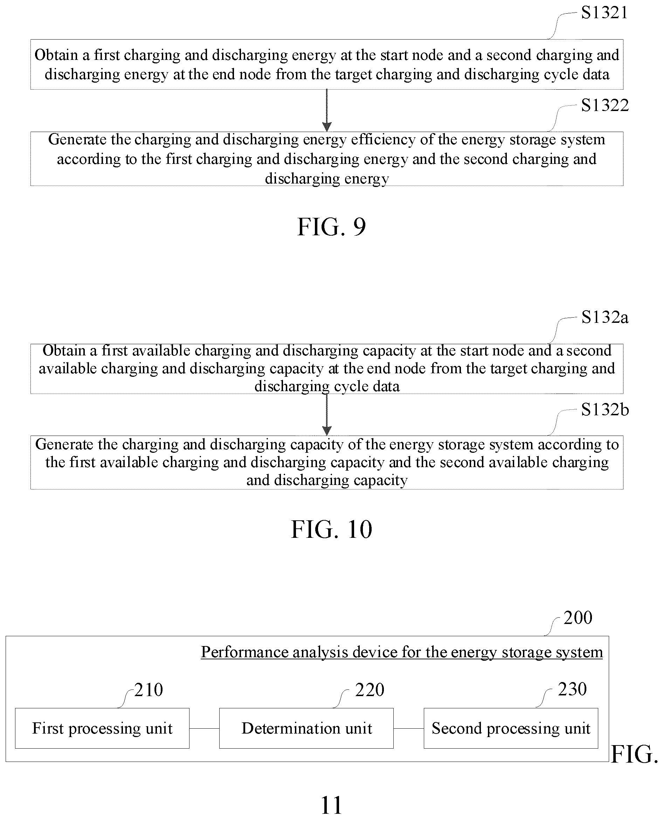

In other embodiments, as shown in FIG. 9, the step S132 includes steps S1321 and S1322.

In S1321, a first charging and discharging energy at the start node and a second charging and discharging energy at the end node are obtained from the target charging and discharging cycle data.

In S1322, the energy efficiency during charging and discharging of the energy storage system is generated according to the first charging and discharging energy and the second charging and discharging energy.

In the embodiments, the first charging and discharging energy includes a first charging energy and a first discharging energy, and the second charging and discharging energy includes a second charging energy and a second discharging energy. The first charging energy refers to the cumulative charging energy of the energy storage system at the beginning of charging; the second charging energy refers to the cumulative charging energy of the energy storage system after charging is completed; the first discharging energy refers to the cumulative discharging energy of the energy storage system at the beginning of discharging; and the second discharging energy refers to the cumulative discharging energy of the energy storage system after discharging is completed.

After the first charging energy, the second charging energy, the first discharging energy and the second discharging energy are obtained, the energy quantity charged during the charging phase and the energy quantity discharged during the discharging phase of the energy storage system may be calculated, and the charging and discharging energy efficiency of the energy storage system may be obtained by dividing the two calculated energy quantities. The charging and discharging energy efficiency refers to the efficiency with which the energy storage system can release energy after being fully charged.

In other embodiments, as shown in FIG. 10, the step S132 also includes steps S132a and S132b.

In S 132a, a first available charging and discharging capacity at the start node and a second available charging and discharging capacity at the end node are obtained from the target charging and discharging cycle data.

In S132b, a charging and discharging capacity of the energy storage system is generated according to the first available charging and discharging capacity and the second available charging and discharging capacity.

In the embodiments, the performance analysis result further includes the charging and discharging capacity, which includes a charging capacity and a discharging capacity. The charging capacity refers to the capacity that can be charged into the energy storage system during the charging phase in a charge and discharge cycle, and the discharging capacity refers to the capacity that can be discharged from the energy storage system during the discharging phase in the charge and discharge cycle. In addition, the first available charging and discharging capacity includes a first available charging capacity and a first available discharging capacity, and the second available charging and discharging capacity includes a second available charging capacity and a second available discharging capacity. The first available charging capacity refers to the capacity that can be charged into the energy storage system at the start node in the charge and discharge cycle, the first available discharging capacity refers to the capacity that can be discharged from the energy storage system at the start node in the charge and discharge cycle, the second available charging capacity refers to the capacity that can be charged into the energy storage system at the end node in the charge and discharge cycle, and the second available discharging capacity refers to the capacity that can be discharged from the energy storage system at the end node in the charge and discharge cycle.

After the first available charging and discharging capacity and the second available charging and discharging capacity are obtained from the target charging and discharging cycle data, the first available charging capacity of the first available charging and discharging capacity may be subtracted from the second available charging capacity of the second available charging and discharging capacity, and the first available discharging capacity of the first available charging and discharging capacity may be subtracted from the second available discharging capacity of the second available charging and discharging capacity. Thus, the charging capacity during the charging phase and the discharging capacity during the discharging phase in the charge and discharge cycle of the energy storage system may be obtained, thereby assessing the performance of the energy storage system according to the charging capacity and the discharging capacity.

In other embodiments, the performance analysis method of the energy storage system further includes a step in which at least one of a charge status curve of the energy storage system, a charge status curve of the energy storage object(s), a charging and discharging voltage curve of the energy storage object(s), and a charging and discharging temperature curve of the energy storage object(s) is generated according to the target charging and discharging data.

After the target charging and discharging data of the energy storage system is obtained, at least one of the charge status curve of the energy storage system, the charge status curve of the energy storage object(s), the charging and discharging voltage curve of the energy storage object(s) and the charging and discharging temperature curve of the energy storage object(s) may be generated and visually displayed. For example, as shown in FIG. 2, a data visualization module may be provided in the present application, and the data visualization module corresponds to the button of curves drawing shown in FIG. 2. When any one of the charge status curve of the energy storage system, the charge status curve of the energy storage object(s), the charging and discharging voltage curve of the energy storage object(s), and the charging and discharging temperature curve of the energy storage object(s) needs to be visually displayed, the corresponding button of curves drawing needs to be simply selected to generate of a corresponding visual curve, facilitating human review.

In addition, when the corresponding curve chart is generated in the present application, a specific point may also be annotated on the chart. For example, the highest voltage to the lowest voltage of the energy storage object(s) at the charging end node may be numbered and numerically annotated, which may quickly locate the number and position of the abnormal energy storage object(s) in the energy storage system.

For the performance analysis method of the energy storage system provided in the embodiments of the present application, the at least one data file of charging and discharging of the energy storage system is processed to obtain the target charging and discharging data, the target charging and discharging data including the charging and discharging cycle data after at least one charging and discharging cycle of the energy storage system, the charging and discharging cycle data including the charging and discharging cycle data of at least one energy storage object, and each of the energy storage object(s) including any one of the battery cluster, the battery pack, the battery module, or the battery cell in the energy storage system; the start node and the end node in the charging and discharging cycle of the energy storage system are determined according to the charging and discharging cycle data of the at least one energy storage object; and the target charging and discharging data is processed according to the start node and the end node to obtain the performance analysis result of the energy storage system. In the present application, the process of charging and discharging data is achieved without the need for manual methods, which may not only avoid the situation of misreading and omission, but also improve the processing efficiency of the charging and discharging data of the energy storage system. In addition, the charging and discharging cycle data of the energy storage object(s) is directly used to locate the start node and the end node in the charging and discharging cycle of the energy storage system, which has a relatively high accuracy, thereby accurately analyzing the performance of the energy storage system.

Embodiments of the present application provide a performance analysis device 200 for the energy storage system, and the performance analysis device 200 is used to perform the performance analysis method of the energy storage system in any one of the embodiments.

Referring to FIG. 11, FIG. 11 is a schematic block diagram of the performance analysis device 200 for the energy storage system provided in embodiments of the present application.

As shown in FIG. 11, the performance analysis device 200 for the energy storage system includes: a first processing unit 210, a determination unit 220 and a second processing unit 230.

The first processing unit 210 is used to process at least one data file after charging and discharging of the energy storage system to obtain a target charging and discharging data; the target charging and discharging data including charging and discharging cycle data after at least one charging and discharging cycle of the energy storage system, the charging and discharging cycle data including charging and discharging cycle data of at least one energy storage object, and the energy storage object including any one of a battery cluster, a battery pack, a battery module and a battery cell in the energy storage system.

In other embodiments, the performance analysis device 200 for the energy storage system is further used to determine a file folder containing one or more data files of charging and discharging of the energy storage system to obtain the at least one data file.

In other embodiments, the first processing unit 210 is specifically used to merge a plurality of data files to obtain a merged data file; and perform data screening on the merged data file to obtain the target charging and discharging data.

The determination unit 220 is used to determine a start node and an end node in the charging and discharging cycle of the energy storage system according to the charging and discharging cycle data of the at least one energy storage object.

In other embodiments, the determination unit 220 is specifically used to: determine a charging end node of the energy storage system according to the charging and discharging cycle data of the at least one energy storage object; and determine a charging start node, a discharging end node and a discharging start node of the energy storage system from the charging and discharging cycle data of an energy storage object corresponding to the charging end node.

In other embodiments, the determination unit 220 is specifically used to: obtain a highest voltage of at least one unit from the charging and discharging cycle data of the at least one energy storage object; and determine the charging end node of the energy storage system according to the highest voltage of the at least one unit.

In other embodiments, the determination unit 220 is specifically used to: determine the charging start node and the discharging end node from the charging and discharging cycle data of the energy storage object corresponding to the charging end node; obtain intermediate data between the charging end node and the discharging end node from the charging and discharging cycle data of the energy storage object corresponding to the charging end node; and determine the discharging start node according to the intermediate data.

The second processing unit 230 is used to process the target charging and discharging data according to the start node and the end node to obtain a performance analysis result of the energy storage system.

In other embodiments, the second processing unit 230 is specifically used to: obtain target charging and discharging cycle data between the start node and the end node from the target charging and discharging data; and analyze a performance of the energy storage system according to the target charging and discharging cycle data to obtain the performance analysis result of the energy storage system.

In other embodiments, the second processing unit 230 is specifically used to: obtain a lowest temperature at the start node and a highest temperature at the end node from the target charging and discharging cycle data; and generate a temperature rise during charging and discharging of the energy storage system according to the highest temperature and the lowest temperature.

In other embodiments, the second processing unit 230 is specifically used to: obtain a first charging and discharging energy at the start node and the second charging and discharging energy at the end node from the target charging and discharging cycle data; and generate a charging and discharging energy efficiency of the energy storage system according to the first charging and discharging energy and the second charging and discharging energy.

In other embodiments, the second processing unit 230 is specifically used to: obtain a first charging and discharging capacity at the start node and a second charging and discharging capacity at the end node from the target charging and discharging cycle data; and generate a charging and discharging capacity of the energy storage system according to the first charging and discharging capacity and the second charging and discharging capacity.

In other embodiments, the performance analysis device 200 for the energy storage system is further used to: generate at least one of a charge status curve of the energy storage system, a charge status curve of the at least one energy storage object, a charging and discharging voltage curve of the at least one energy storage object, and a charging and discharging temperature curve of the at least one energy storage object according to the target charging and discharging data.

The performance analysis device 200 for the energy storage system provided in the present application is used to: process the at least one data file of charging and discharging of the energy storage system to obtain the target charging and discharging data, the target charging and discharging data including the charging and discharging cycle data after at least one charging and discharging cycle of the energy storage system, the charging and discharging cycle data including the charging and discharging cycle data of at least one energy storage object, and each of the energy storage object(s) including any one of the battery cluster, the battery pack, the battery module, or the battery cell in the energy storage system; the start node and the end node in the charging and discharging cycle of the energy storage system are determined according to the charging and discharging cycle data of the at least one energy storage object; and the target charging and discharging data is processed according to the start node and the end node to obtain the performance analysis result of the energy storage system.

It will be noted that, those skilled in the art can clearly understand that the specific implementation processes of the performance analysis device 200 and each unit therein can refer to the corresponding description in the embodiments of the performance analysis method of the energy storage system, and are not repeated here for the convenience and simplicity of the description.

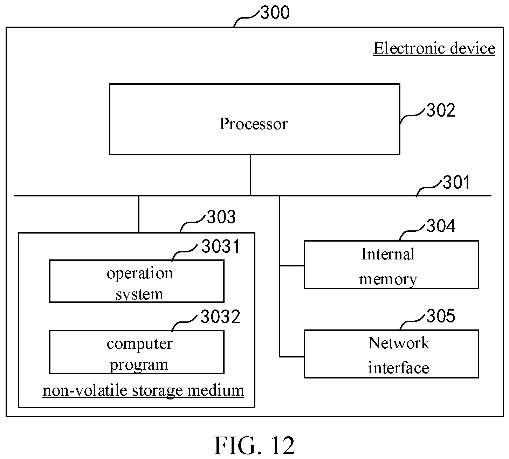

The performance analysis device 200 for the energy storage system may be implemented as a form of computer program, which may run on an electronic device as shown in FIG. 12.

Referring to FIG. 12, FIG. 12 is a schematic block diagram of an electronic device provided in embodiments of the present application. The electronic device 300 may be a terminal, and the terminal may be a cloud terminal, a terminal device in a vehicle, a smartphone, a tablet computer, a laptop computer, a desktop computer, a personal digital assistant, and a wearable device, etc.

Referring to FIG. 12, the electronic device 300 includes a processor 302, a memory, and a network interface 305 that are connected through a system bus 301, where the memory may include a non-volatile storage medium 303 and an internal memory 304.

The non-volatile storage medium 303 may store an operation system 3031 and a computer program 3032. The computer program 3032 includes program instructions that, when executed, enable the processor 302 to execute the performance analysis method of the energy storage system.

The processor 302 is used to provide computational and control capabilities to support the operation of the entire electronic device 300.

The internal memory 304 provides an environment for the operation of the computer program 3032 in the non-volatile storage medium 303. When executed by the processor 302, the computer program 3032 enables the processor 302 to perform the performance analysis method of the energy storage system.

The network interface 305 is used for network communication with other device(s). Those skilled in the art can understand that the structure as shown in FIG. 12 may be a portion of the structure related to the scheme of the present application, and does not constitute a limitation on the electronic device 300 to which the scheme of the present application is applied. The specific electronic device 300 may include more or fewer components than those shown in the figure, or combine some components, or have different arrangement of the components.

The processor 302 is used such that the computer program 3032 stored in the memory runs to achieve the following steps. At least one data file of charging and discharging of the energy storage system is processed to obtain the target charging and discharging data, the target charging and discharging data including the charging and discharging cycle data after at least one charging and discharging cycle of the energy storage system, the charging and discharging cycle data including the charging and discharging cycle data of at least one energy storage object, and each of the energy storage object(s) including any one of the battery cluster, the battery pack, the battery module, or the battery cell in the energy storage system; the start node and the end node in the charging and discharging cycle of the energy storage system are determined according to the charging and discharging cycle data of the at least one energy storage object; and the target charging and discharging data is processed according to the start node and the end node to obtain the performance analysis result of the energy storage system.

In the embodiments of the present application, it will be understood that the processor 302 may be a central processing unit (CPU). The processor 302 may also be other general-purpose processor, digital signal processor (DSP), application-specific integrated circuit (ASIC), field programmable gate array (FPGA), other programmable logic device, discrete device, gate or transistor logic device, discrete hardware component, or the like. The general-purpose processor may be a microprocessor, or any conventional processor.

A computer program product or computer program is provided according to an aspect of the present application, the computer program product or the computer program includes computer instructions stored on a computer-readable storage medium. The processor of the electronic device reads the computer instructions from the computer-readable storage medium, and the processor executes the computer instructions to enable the electronic device to achieve the following steps. At least one data file of charging and discharging of the energy storage system is processed to obtain the target charging and discharging data, the target charging and discharging data including the charging and discharging cycle data after at least one charging and discharging cycle of the energy storage system, the charging and discharging cycle data including the charging and discharging cycle data of at least one energy storage object, and each of the energy storage object(s) including any one of the battery cluster, the battery pack, the battery module, or the battery cell in the energy storage system; the start node and the end node in the charging and discharging cycle of the energy storage system are determined according to the charging and discharging cycle data of the at least one energy storage object; and the target charging and discharging data is processed according to the start node and the end node to obtain the performance analysis result of the energy storage system.

Those skilled in the art can understand that the implementation of part of or all processes in the performance analysis method of the energy storage system may be completed by instructing relevant hardware with a computer program. The computer program includes program instructions, and the computer program may be stored in a storage medium, which is a computer-readable storage medium. The computer-readable storage medium may be non-volatile or volatile. The program instructions are executed by at least one processor in the computer system to implement the processes of the performance analysis method of the energy storage system.

A storage medium is provided in the present application. The storage medium may be a computer-readable storage medium. The storage medium has stored thereon a computer program, which includes program instructions. When the program instructions are executed by the processor, the processor performs the following steps. At least one data file of charging and discharging of the energy storage system is processed to obtain the target charging and discharging data, the target charging and discharging data including the charging and discharging cycle data after at least one charging and discharging cycle of the energy storage system, the charging and discharging cycle data including the charging and discharging cycle data of at least one energy storage object, and each of the energy storage object(s) including any one of the battery cluster, the battery pack, the battery module, or the battery cell in the energy storage system; the start node and the end node in the charging and discharging cycle of the energy storage system are determined according to the charging and discharging cycle data of the at least one energy storage object; and the target charging and discharging data is processed according to the start node and the end node to obtain the performance analysis result of the energy storage system.

The storage medium may be a USB flash drive, an external hard drive, a read-only memory (ROM), a disk, an optical disc, or any other computer-readable storage media that can store the program code.

## Claims

1. A performance analysis method of an energy storage system, **characterized in that** the performance analysis method of the energy storage system comprises:
processing at least one data file of charging and discharging of the energy storage system to obtain target charging and discharging data, wherein the target charging and discharging data comprises charging and discharging cycle data after at least one charging and discharging cycle of the energy storage system, the charging and discharging cycle data comprises charging and discharging cycle data of at least one energy storage object, and the at least one energy storage object comprises any one of a battery cluster, a battery pack, a battery module and a battery cell in the energy storage system;
determining a start node and an end node in the charging and discharging cycle of the energy storage system according to the charging and discharging cycle data of the at least one energy storage object; and
processing the target charging and discharging data according to the start node and the end node to obtain a performance analysis result of the energy storage system.

2. The performance analysis method of the energy storage system according to claim 1, **characterized in that** the start node comprises a charging start node and a discharging start node, and the end node comprises a charging end node and a discharging end node;
wherein the determining of the start node and the end node in the charging and discharging cycle of the energy storage system according to the charging and discharging cycle data of the at least one energy storage object comprises:
determining the charging end node in the charging and discharging cycle of the energy storage system and charging and discharging cycle data of the energy storage object corresponding to the charging end node according to the charging and discharging cycle data of the at least one energy storage object; and
determining the charging start node, the discharging end node and the discharging start node of the energy storage system from the charging and discharging cycle data of the energy storage object corresponding to the charging end node.

3. The performance analysis method of the energy storage system according to claim 2, **characterized in that** the determining of the charging end node of the energy storage system according to the charging and discharging cycle data of the at least one energy storage object comprises:
obtaining a highest voltage of at least one unit from the charging and discharging cycle data of the at least one energy storage object; and
determining the charging end node in the charging and discharging cycle of the energy storage system according to the highest voltage of the at least one unit.

4. The performance analysis method of the energy storage system according to claim 2, **characterized in that** the determining of the charging start node, the discharging end node and the discharging start node of the energy storage system from the charging and discharging cycle data of the energy storage object corresponding to the charging end node comprises:
determining the charging start node and the discharging end node from the charging and discharging cycle data of the energy storage object corresponding to the charging end node;
obtaining intermediate data between the charging end node and the discharging end node from the charging and discharging cycle data of the energy storage object corresponding to the charging end node; and
determining the discharging start node according to the intermediate data.

5. The performance analysis method of the energy storage system according to any one of claims 1 to 4, **characterized in that** the processing of the target charging and discharging data according to the start node and the end node to obtain the performance analysis result of the energy storage system comprises:
obtaining target charging and discharging cycle data between the start node and the end node from the target charging and discharging data; and
analyzing a performance of the energy storage system according to the target charging and discharging cycle data to obtain the performance analysis result of the energy storage system.

6. The performance analysis method of the energy storage system according to claim 5, **characterized in that** the performance analysis result comprises a temperature rise during charging and discharging;
wherein the analyzing of the performance of the energy storage system according to the target charging and discharging cycle data to obtain the performance analysis result of the energy storage system comprises:
obtaining a lowest temperature at the start node and a highest temperature at the end node from the target charging and discharging cycle data; and
generating the temperature rise during charging and discharging of the energy storage system according to the highest temperature and the lowest temperature.

7. The performance analysis method of the energy storage system according to claim 5, **characterized in that** the performance analysis result further comprises an energy efficiency during charging and discharging;
wherein the analyzing of the performance of the energy storage system according to the target charging and discharging cycle data to obtain the performance analysis result of the energy storage system comprises:
obtaining a first charging and discharging energy at the start node and a second charging and discharging energy at the end node from the target charging and discharging cycle data; and
generating the charging and discharging energy efficiency of the energy storage system according to the first charging and discharging energy and the second charging and discharging energy.

8. The performance analysis method of the energy storage system according to claim 5, **characterized in that** the performance analysis result further comprises a charging and discharging capacity;
wherein the analyzing of the performance of the energy storage system according to the target charging and discharging cycle data to obtain the performance analysis result of the energy storage system comprises:
obtaining a first available charging and discharging capacity at the start node and a second available charging and discharging capacity at the end node from the target charging and discharging cycle data; and
generating the charging and discharging capacity of the energy storage system according to the first available charging and discharging capacity and the second available charging and discharging capacity.

9. The performance analysis method of an energy storage system according to any one of claims 1 to 4, **characterized in that** the performance analysis method of the energy storage system further comprises:
generating at least one of a charge status curve of the energy storage system, a charge status curve of the at least one energy storage object, a charging and discharging voltage curve of the at least one energy storage object, and a charging and discharging temperature curve of the at least one energy storage object according to the target charging and discharging data.

10. The performance analysis method of an energy storage system according to any one of claims 1 to 4, **characterized in that** before the processing of the at least one data file of the charging and discharging of the energy storage system to obtain the target charging and discharging data, the performance analysis method further comprises:
determining a file folder containing one or more data files of charging and discharging of the energy storage system to obtain the at least one data file.

11. The performance analysis method of an energy storage system according to any one of claims 1 to 4, **characterized in that** the at least one data file comprises a plurality of data files, and the processing of the at least one data file of the charging and discharging of the energy storage system to obtain the target charging and discharging data comprises:
merging the plurality of data files to obtain a merged data file; and
performing data screening on the merged data file to obtain the target charging and discharging data.

12. A performance analysis device for an energy storage system, **characterized in that** the performance analysis device comprises:
a first processing unit (210) used to process at least one data file of charging and discharging of the energy storage system to obtain target charging and discharging data, wherein the target charging and discharging data comprises charging and discharging cycle data after at least one charging and discharging cycle of the energy storage system, the charging and discharging cycle data comprises charging and discharging cycle data of at least one energy storage object, and the at least one energy storage object comprises any one of a battery cluster, a battery pack, a battery module and a battery cell in the energy storage system;
a determination unit (220) used to determine a start node and an end node in the charging and discharging cycle of the energy storage system according to the charging and discharging cycle data of the at least one energy storage object; and
a second processing unit (230) used to process the target charging and discharging data according to the start node and the end node to obtain a performance analysis result of the energy storage system.

13. An electronic device, **characterized in that** the electronic device comprises a memory and a processor, wherein the memory stores a computer program, and the processor, when executing the computer program, implements steps of the performance analysis method of the energy storage system as described in any one of claims 1 to 11.

14. A computer-readable storage medium, **characterized in that** the computer-readable storage medium has stored thereon a computer program that, when executed by a processor, implements steps of the performance analysis method of the energy storage system as described in any one of claims 1 to 11.

15. A computer program product, **characterized in that** the computer program product comprises a computer program, wherein the computer program when executed by a processor, implements steps of the charging and discharging performance analysis method of the energy storage system as described in any one of claims 1 to 11.
